(19)

Europäisches
Patentamt
European
Patent Office
Office européen
des brevets

(11) **EP 2 908 374 A1**

(12) **EUROPEAN PATENT APPLICATION**

(43) Date of publication:
**19.08.2015 Bulletin 2015/34**

(51) Int Cl.:
*H01M 8/18* (2006.01)        *G01R 31/36* (2006.01)
*H01M 8/20* (2006.01)        *H01M 8/04* (2006.01)

(21) Application number: **15154653.8**

(22) Date of filing: **11.02.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **12.02.2014   KR 20140016075**

(71) Applicant: **OCI Company Ltd.
Seoul 100-718 (KR)**

(72) Inventors:
• **KIM, Jae-Min
462-807 Gyeonggi-do (KR)**

• **LEE, Ji-Young
462-807 Gyeonggi-do (KR)**
• **LEE, Seung-Yoen
462-807 Gyeonggi-do (KR)**
• **KIM, Soo-Whan
462-807 Gyeonggi-do (KR)**
• **YE, Hee-Chang
462-807 Gyeonggi-do (KR)**

(74) Representative: **Björk, Frida Magdalena
Awapatent AB
Bellevuevägen 46
P.O. Box 5117
200 71 Malmö (SE)**

(54) **METHOD AND SYSTEM FOR EVALUATING REDOX FLOW BATTERY**

(57)     A system for evaluating a redox flow battery according to an embodiment of the present disclosure includes: a control unit configured to control the path of a flow channel connected between a detection cell and the redox flow battery or a flow channel connected between the detection cell and an agitator; and an evaluation unit configured to evaluate any one of the state of charge, capacity fade and oxidation number balance of an electrolyte, which is used in the redox flow battery, by measuring a current or voltage of the detection cell based on the controlling of the path by the control unit. According to the present disclosure, the capacity fade problem of a redox flow battery can be quickly coped with by evaluating the information of the positive and negative electrode electrolytes on battery capacity fade and information about the valence balance of the electrolytes *in* situ.

FIG. 1

**Description**

**BACKGROUND**

1. Technical Field

The present disclosure relates to a method and system for evaluating a redox flow battery, and more particularly, to a method and system of evaluating the state of the electrolyte of a redox flow battery *in situ* in order to overcome the capacity fade of the redox flow battery.

2. Related Art

A redox flow battery is an electrochemical energy storage device that stores or releases electrical energy through the redox reactions of ions contained in the electrolyte. The positive electrolyte and negative electrolyte of the redox flow battery are separated from each other by an electrolyte membrane, and diffusion occurs due to the difference in the concentration of ions across the electrolyte membrane.
However, because the diffusion velocity of active material varies depending on the type of active material, a phenomenon occurs in which the amount of the active material is biased to any one of the positive electrode and the negative electrode with the passage of time. This phenomenon causes an imbalance in the capacity of the active materials to reduce electrolyte availability, thereby reducing the battery capacity. This phenomenon is known as capacity fade caused by the crossover of the active materials.
In an attempt to overcome the capacity fade cause by an imbalance in the capacity of the active materials, there is a method in which positive and negative electrolytes are mixed with each other, and then divided into halves so that the active materials of the positive and negative electrolytes have the same oxidation number. This method is known as a total mixing method. However, this method has disadvantages in that both the pump energy required for mixing the positive and negative electrolytes with each other and the energy of the battery in a charged state are lost and in that a large amount of time is required until the mixing of the positive and negative electrolytes (total mixing) is completed.
To eliminate this waste of energy and time, a technology is used in which an active material corresponding to battery capacity fade is partially transferred from one to another electrolyte tank. This is known as partial transfer. To apply this technology, the information of positive and negative electrolytes on battery capacity fade should be evaluated in advance.
Meanwhile, in addition to capacity fade caused by an imbalance in the capacity of the active materials of positive and negative electrolytes, capacity fade by an imbalance in the valence of the active materials can occur. Theoretically, the valence balance of positive and negative electrolytes should be always maintained constant while they form a redox pair. However, a redox reaction may independently occur in only one of the electrolytes due to side reactions caused by air inflow, overvoltage and the like during the use of the battery. As a result, a phenomenon occurs in which the valence balance of the positive and negative electrolytes breaks. It is theoretically possible that capacity fade caused by crossover of active materials can be restored to a capacity of 100% by the total mixing or partial transfer as mentioned above. However, the valence imbalance of active materials by an irreversible reaction results in permanent battery capacity fade, and for this reason, the valence balance of active materials needs to be evaluated independently of capacity fade during the evaluation of electrolytes.

**SUMMARY**

It is an object of the present disclosure to provide a method and system for evaluating a redox flow battery, which can quickly cope with the capacity fade problem of the redox flow battery by evaluating the information of the positive and negative electrolytes on battery capacity fade and information about the valence balance of the positive and negative electrolytes *in situ.*
Another object of the present disclosure is to provide a method and system for evaluating a redox flow battery, which enables the energy of the redox flow battery to be efficiently controlled and steadily used, and can improve the reliability of performance of the redox flow battery.
The objects of the present disclosure are not limited to the above-mentioned objects, and other objects and advantages of the present disclosure will be more clearly understood by the following detailed description and embodiments of the present disclosure. In addition, it can be easily understood that the objects and advantages of the present disclosure can be realized by the means set forth in the claims and combinations thereof.
In an embodiment, a system for evaluating a redox flow battery includes: a control unit configured to control the path of a flow channel connected between a detection cell and the redox flow battery or a flow channel connected between the detection cell and an agitator; and an evaluation unit configured to evaluate any one of the state of charge, capacity fade and oxidation number balance of an electrolyte, which is used in the redox flow battery, by measuring the current or voltage of the detection cell based on the controlling of the path.

In another embodiment, a method for evaluating a redox flow battery includes the steps of: controlling the path of a flow channel connected between a detection cell and the redox flow battery or a flow channel connected between the detection cell and an agitator; and evaluating any one of the state of charge, capacity fade and oxidation number balance of an electrolyte, which is used in the redox flow battery, by measuring the current or voltage of the detection cell based on the controlling of the path.

**BRIEF DESCRIPTION OF THE DRAWINGS**

FIG. 1 is a view showing the configuration of a system for evaluating a redox flow battery according to an embodiment of the present disclosure.

FIGS. 2 and 3 are views illustrating the operation of three-way valves that are used in a system for evaluating a redox flow battery according to the present disclosure.

FIG. 4 is a view illustrating the operation of a system for evaluating a redox flow battery according to a first embodiment of the present disclosure.

FIG. 5 is a graph showing a comparison between the state of charge measured according to the first embodiment of the present disclosure and a theoretically calculated state of charge.

FIG. 6 is a view illustrating the operation of a system for evaluating a redox flow battery according to a second embodiment of the present disclosure.

FIG. 7 is a graph showing a comparison between the capacity of a detection cell, measured in a first embodiment, and the capacity of the main stack of a redox flow battery.

FIG. 8 is a view illustrating the operation of a system for evaluating a redox flow battery according to a third embodiment of the present disclosure.

FIG. 9 is a graph showing state-of-charge versus voltage curves of a detection cell, produced according to the third embodiment of the present disclosure.

FIG. 10 is a flow chart showing a method for evaluating a redox flow battery according to an embodiment of the present disclosure.

**DETAILED DESCRIPTION**

Exemplary embodiments will be described below in more detail with reference to the accompanying drawings. The disclosure may, however, be embodied in different forms and should not be constructed as limited to the embodiments set forth herein. Rather, these embodiments are provided so that this disclosure will be thorough and complete, and will fully convey the scope of the disclosure to those skilled in the art. Throughout the disclosure, like reference numerals refer to like parts throughout the various figures and embodiments of the disclosure.

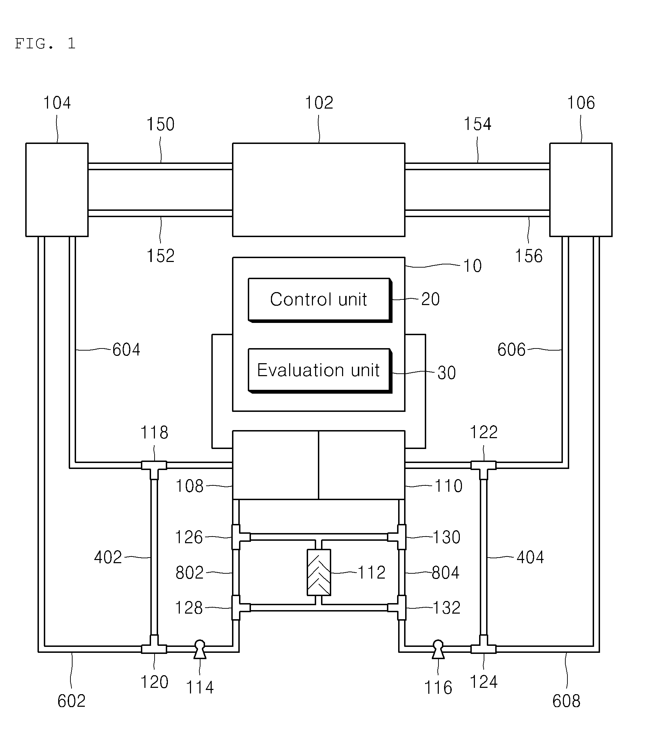

FIG. 1 is a view showing the configuration of a redox flow battery and a redox flow battery evaluation system connected thereto according to an embodiment of the present disclosure.

Referring to FIG. 1, a redox flow battery includes a main stack 102, a first electrolyte tank 104 and a second electrolyte tank 106. The first electrolyte tank 104 is configured to store a first electrolyte that is used in the main stack 102. The first electrolyte discharged from the first electrolyte tank 104 is supplied to the main stack 102 through a flow channel 152, and the first electrolyte used in the main stack is introduced into the first electrolyte tank 104 through a flow channel 150. Similarly, a second electrolyte discharged from the second electrolyte tank 106 is supplied to the main stack 102 through the flow channel 156, and the second electrolyte used in the main stack 102 is introduced into the second electrolyte tank 106 through a flow channel 154.

In an embodiment of the present disclosure, the first electrolyte tank 104 is connected to a first detection cell 108 through a flow channel 602 and a flow channel 604, and the second electrolyte tank 106 is connected to a second detection cell 110 through a flow channel 606 and a flow channel 608. Thus, during the operation of the redox flow battery, the first and second electrolytes that are supplied to the main stack 102 are also supplied to the detection cells 108 and 110 so that the *in situ* evaluation of the electrolytes according to the present disclosure is possible.

In FIG. 1, the flow channels 602 and 604 are connected to three-way valves 120 and 118, respectively, and the flow channels 606 and 608 are connected to three-way valves 122 and 124, respectively. The three-way valves 120 and 118 may be connected to each other by a flow channel 402, and the three-way valves 122 and 124 may be connected to each other by a flow channel 404.

The three-way valve 120 is connected to a three-way valve 128 via a first pump 114 for supplying the first electrolyte, and the three-way valve 124 is connected to a three-way valve 132 via a second pump for supplying the second electrolyte. The three-way valves 128 and 132 may be connected to three-way valves 126 and 130, respectively, through flow channels 802 and 804, or may also be connected to three-way valves 126 and 130 via an agitator 112. Also, the three-way valve 126 is connected to the first detection cell 108, and the three-way valve 130 is connected to the second detection cell 110.

The first electrolyte introduced into the first detection cell 108 through the above-described flow channels is recovered into the first electrolyte tank 104 via the three-way valve 118. In addition, the second electrolyte introduced into the second detection cell 110 is recovered into the second electrolyte tank 106 via the three-way valve 122.

Meanwhile, to the positive electrodes of the detection cells 108 and 110, there may be connected a redox flow battery evaluation system 10 according to an embodiment of the present disclosure. The redox flow battery evaluation system 10 includes a control unit 20 and an evaluation unit 30.

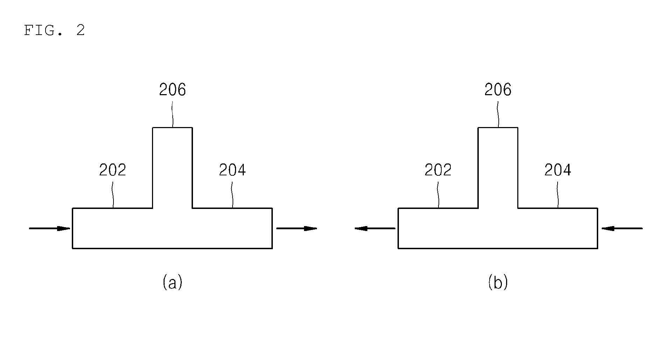

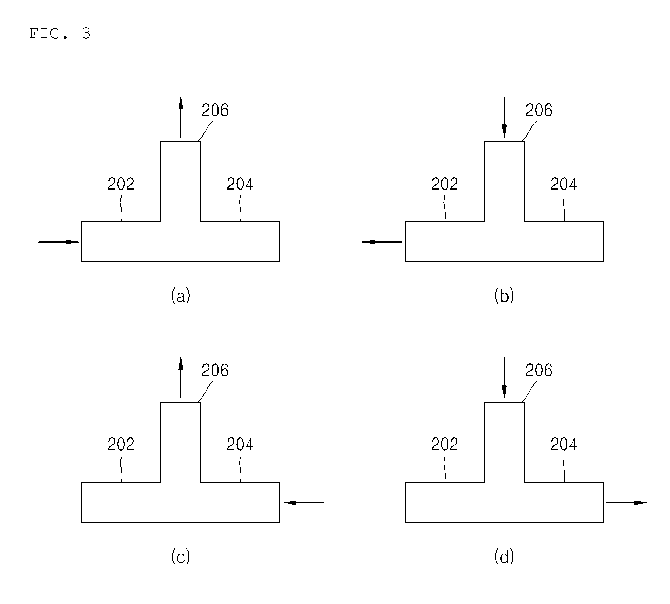

The control unit 20 is configured to control either the paths of flow channels connected between the detection cells 108 and 110 and the electrolyte tanks 104 and 106 or the paths of flow channels connected between the detection cells 108 and 110 and the agitator 112. To control the path of each of these flow channels, the control unit 20 can control the on/off state of the three-way valves 118, 120, 122, 124, 126, 128, 130 and 132 to the flow channels. The operation of the three-way valves by the control unit 20 will be described in further detail with reference to FIGS. 2 and 3.

FIGS. 2 and 3 illustrate the operation of three-way valves that are used in a redox flow battery evaluation system according to an embodiment of the present disclosure.

FIG. 2 shows the flow of a fluid when a three-way valve is maintained in an "off" state by the control unit 20. When the three-way valve is in an "off" state, a fluid flows from a left end 202 to a right end 204 as shown in FIG. 2(a), or flows from the right end 204 to the left end 202 as shown in FIG. 2(b).

FIG. 3 shows the flow of a fluid when a three-way valve is maintained in an "on" state by the control unit 20. When a three-way valve is in an "on" state, a fluid flows at an angle of 90° as shown in FIG. 3. Specifically, the fluid can flow from the left end 202 to the central end 206 as shown in FIG. 3(a), or can flow from the central end 206 to the left end 202 as shown in FIG. 3(b). In addition, the fluid can flow from the right end 204 to the central end 206 as shown in FIG. 3(c), or can flow from the central end 206 to the right end 204 as shown in FIG. 3(d).

Referring to FIG. 1 again, the evaluation unit 30 is configured to evaluate any one of the state of charge, the capacity fade and the oxidation number balance of the electrolytes, which are used in the redox flow battery, by measuring the currents or voltages of the detection cells 108 and 110 according to the flow channel paths controlled by the control unit 20.

Hereinafter, the control of flow paths by the control unit 20 in each embodiment, and the evaluation of the state of charge, the capacity fade and the oxidation number balance of electrolytes, which are used in a redox flow cell, by the evaluation unit 30 in each embodiment, will be described in detail.

First embodiment - mode for evaluation of state of charge

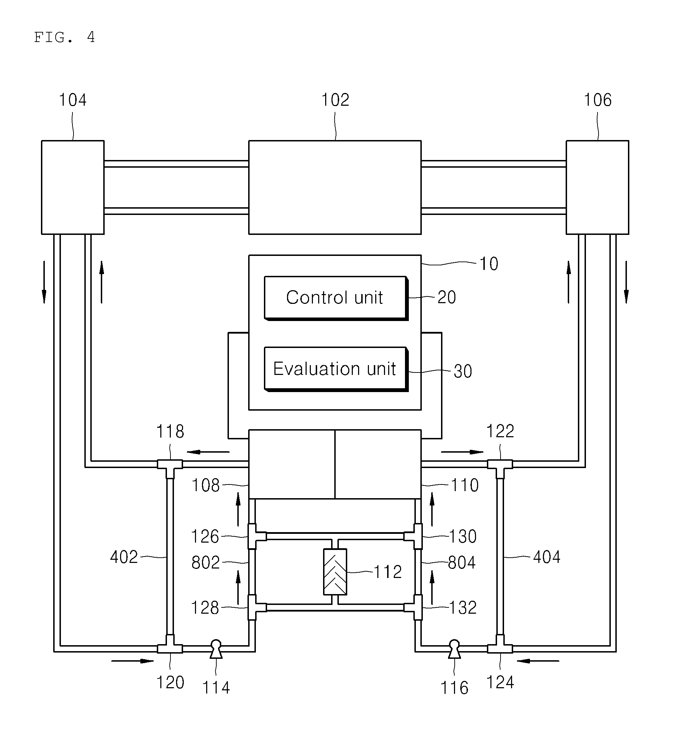

FIG. 4 is a view illustrating the operation of a redox flow battery evaluation system according to a first embodiment of the present disclosure.

Referring to FIG. 4, the control unit 20 controls the on/off state of three-way valves 118, 120, 122, 124, 126, 128, 130 and 132 to thereby control the paths of flow channels so that the electrolytes discharged from the electrolyte tanks 104 and 106 will be introduced again into the electrolyte tanks 104 and 106 after passage through the detection cells 108 and 110. The on/off states of three-way valves, which are controlled by the control unit 20 in the first embodiment, are as follows:

- three-way valves 118, 120, 122, 124, 126, 128, 130 and 132: "off" state.

Specifically, the three-way valves 118, 120, 122, 124, 126, 128, 130 and 132 are all maintained in an "off" state, and the movement paths of the first and second electrolytes in this state are as follows:

- movement path of first electrolyte: electrolyte tank 104 → three-way valve 120 → first pump 114 → three-way valve 128 → flow channel 802 → three-way valve 126 → first detection cell 108 → three-way valve 118 → electrolyte tank 104;
- movement path of second electrolyte: electrolyte tank 106 → three-way valve 124 → second pump 116 → three-way valve 132 → flow channel 804 → three-way valve 130 → second detection cell 110 → three-way valve 122 → electrolyte tank 106.

While the electrolytes discharged from the electrolyte tanks 104 and 106 are introduced again into the electrolyte tanks 104 and 106 after passage through the detection cells 108 and 110 as described above, the elevation unit 30 measures the voltage (i.e., open circuit voltage (OCV)) of the detection cells 108 and 110, and determines the state of charge (SOC) of the redox flow battery based on the measured open circuit voltage. For determination of the state of charge (SOC), the following equation 1 is used:

Equation 1

$$SOC\,(\%) = \left\{ EXP\left[ -\frac{F}{2RT}(OCV - OCV^0) \right] + 1 \right\}^{-1} \times 100$$

wherein SOC represents the state of charge of the redox flow battery, OCV represents the open circuit voltage of the detection cells 108 and 110, R represents gas constant, T represents absolute temperature, and F represents Faraday constant.

The evaluation unit 30 can calculate the state of charge of the electrolytes in the detection cells 108 and 110 by substituting the measured open circuit voltage of the detection cell 108 and 110 into equation 1. Herein, the evaluation unit 30 can determine the state of charge of the electrolytes in the detection cells 108 and 110, calculated by equation 1, as the state of charge of the electrolytes that are used in the redox flow battery, because the detection cells 108 and 110 share the electrolytes with the stack 102. Equation 1 is one of exemplary equations representing the relationship between SOC (%) and OCV (V), and SOC may also be calculated using equations other than equation 1.

The state of charge determined by the evaluation unit 30 is an index indicative of the current state of energy storage in the redox flow battery, and can be used to determine the upper and lower limits of energy charge or discharge of the battery. Thus, the evaluation of the state of charge by the evaluation unit 30 is a key element in the stable control of energy in the redox flow battery.

For reference, equation 1 can be derived as follows. The voltage of the electrolyte is determined according to the ratio of the concentration of an oxidation product to the concentration of a reduction product as shown in the following equation 2:

Equation 2

$$V = V^0 + \frac{RT}{zF}\ln\left( \frac{[\text{concentration of oxidation product}]}{[\text{concentration of reduction product}]} \right)$$

wherein V is the voltage value of the electrolyte, $V^0$ is the characteristic value of the electrolyte, calculated when the concentration of the electrolyte oxidation product is the same as that of the electrolyte reduction product, R is gas constant, T is absolute temperature, z is the number of moles of electrons exchanged between the oxidation product and the reduction product in a one mole reaction, and F is Faraday constant. In other words, the voltage value of the electrolyte can be calculated by substituting the concentration of the oxidation product and the concentration of the reduction product into equation 2.

For example, an oxidation product and a reduction product on the positive electrode side of a vanadium redox flow electrode $VO_2^+$ (= $V^{5+}$) and $VO_2^+$ (= $V^{4+}$), respectively, and an oxidation product and a reduction product on the negative electrode side are $V^{3+}$ and $V^{2+}$, respectively. Using equation 2, the voltage of the positive electrode electrolyte can be calculated as shown in the following equation 3, and the voltage of the negative electrode electrolyte can be calculated as shown in the following equation 4:

Equation 3

$$V = V^0 + \frac{RT}{zF}\ln\left( \frac{[VO_2^+]}{[VO^{2+}]} \right)$$

Equation 4

$$V = V^0 + \frac{RT}{zF} \ln\left(\frac{[V^{3+}]}{[V^{2+}]}\right)$$

Thus, the concentration of each of the vanadium ions can be calculated as shown in the following equations 5 and 6:

Equation 5

$$\left[VO_2{}^+\right] = Cv \times (1 - SOC), \qquad [VO^{2+}] = Cv \times SOC$$

Equation 6

$$[V^{3+}] = Cv \times (1 - SOC), \qquad [V^{2+}] = Cv \times SOC$$

wherein Cv is the total molar concentration of the vanadium ions contained in each of the positive electrode electrolyte and the negative electrode electrolyte. Generally, when sulfuric acid is used as a solvent, Cv is a concentration of about 1-3 moles, and Cv during the preparation of the electrolyte is a fixed value. As the state of charge (SOC) of the battery increases, the amount of $VO_2{}^+$ (= $V^{5+}$) in a tank storing the positive electrode electrolyte increases, and the amount of $V^{2+}$ in a tank storing the negative electrode electrolyte increases. For example, if SOC is 100%, the amount of $V^{4+}$ in the tank storing the positive electrode layer becomes 0, and thus the amount of $V^{5+}$ becomes Cv.

Accordingly, the voltage of the positive electrode electrolyte and the voltage of the negative electrode electrolyte can be rearranged in the following equations 7 and 8, respectively:

Equation 7

$$V = V^0 + \frac{RT}{zF} \ln\left(\frac{\left[VO_2{}^+\right]}{[VO^{2+}]}\right)$$

$$= V^0 + \frac{RT}{zF} \ln\left(\frac{Cv \times SOC}{CV \times (1 - SOC)}\right)$$

$$= V^0 + \frac{RT}{zF} \ln\left(\frac{SOC}{(1 - SOC)}\right)$$

Equation 8

$$V = V^0 + \frac{RT}{zF} \ln\left(\frac{[V^{3+}]}{[V^{2+}]}\right)$$

$$= V^0 + \frac{RT}{zF} \ln\left(\frac{Cv \times (1 - SOC)}{CV \times SOC}\right)$$

$$= V^0 + \frac{RT}{zF} \ln\left(\frac{(1 - SOC)}{SOC}\right)$$

The difference between the voltage value of the positive electrode electrolyte, calculated according to equation 7, and the voltage value of the negative electrode electrolyte, calculated according to equation 8, becomes the open circuit voltage of the redox flow battery. When these equations are rearranged, an equation representing the relationship between the open circuit voltage (OCV) of the redox flow battery and the state of charge of the redox flow battery can be obtained as shown in the following equation 9:

Equation 9

$$V^+ = V^{+,0} + \frac{RT}{F}\ln\frac{[V^{5+}]}{[V^{4+}]} = V^{+,0} + \frac{RT}{F}\ln\frac{C_v\,SOC}{C_v\,(1-SOC)}$$

$$V^- = V^{-,0} + \frac{RT}{F}\ln\frac{[V^{3+}]}{[V^{2+}]} = V^{-,0} + \frac{RT}{F}\ln\frac{C_v\,(1-SOC)}{C_v\,SOC}$$

$$\mathbf{OCV(V)} = \mathbf{V^+} - \mathbf{V^-} = \mathbf{OCV^0} + \frac{2RT}{F}\ln\left(\frac{SOC}{1-SOC}\right)$$

As a result, from the equation representing the relationship between OCV and SOC, as shown in the last line of equation 9, equation 1 can be derived.

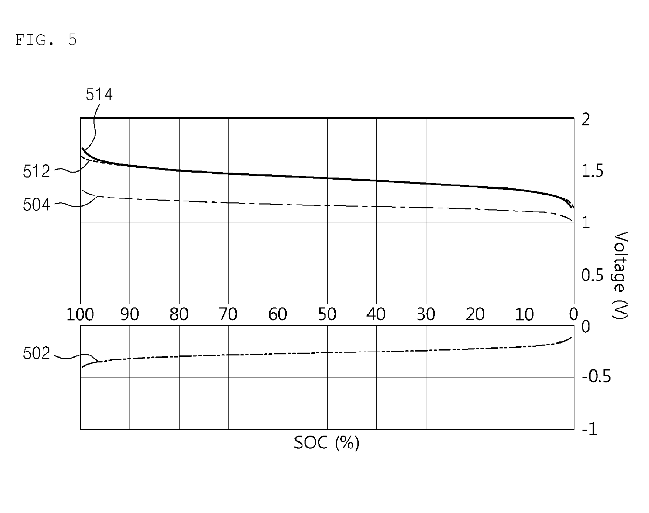

FIG. 5 is a graph showing a comparison between the state of charge, measured in the first embodiment of the present disclosure, and a theoretically calculated state of charge.

In FIG. 5, a curve 504 represents the voltage of the positive electrode electrolyte, and a curve 502 represents the voltage of the negative electrode electrolyte. For reference, the curve 504 and the curve 502 are curves plotted using the values theoretically calculated according to equations 7 and 8, respectively. Also, a curve 512 represents an OCV value determined by calculating the difference between the voltage of the positive electrode electrolyte and the voltage of the negative electrode electrolyte, measured by the evaluation unit 30 of the present disclosure, and a curve 514 represents an OCV value theoretically calculated according to equations 7 and 8.

As shown in FIG. 5, the difference between the OCV value, measured by the evaluation unit 30 of the present disclosure, and the OCV value theoretically calculated according to equations 7 and 8, is very small. Thus, it can be seen that the state of charge of the redox flow battery, determined based on the OCV value measured by the evaluation unit 30 of the present disclosure, has no difference from a theoretical state of charge.

Second embodiment: mode for evaluation of capacity fade

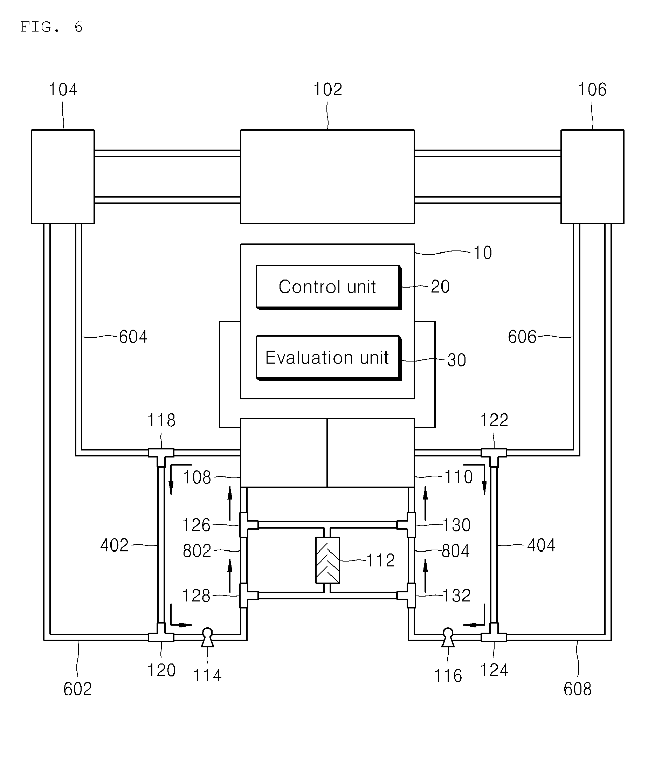

FIG. 6 is a view illustrating the operation of a redox flow battery evaluation system according to a second embodiment of the present disclosure.

Referring to FIG. 6, a control unit 20 is configured to control the on/off states of three-way valves 118, 120, 122, 124, 126, 128, 130 and 132 to thereby control the path of each flow channel so that electrolytes discharged from detection cells 108 and 110 will be introduced again into the detection cells 108 and 110 without passing through tanks 104 and 106 or an agitator 112. The on/off states of the three-way valves, which are controlled by the control unit 20 in the second embodiment, are as follows:

- three-way valves 126, 128, 130 and 132: "off" state;
- three-way valves 118, 120, 122 and 124: "on" state.

Thus, the movement paths of a first electrolyte and a second electrolyte are as follows:

- movement path of first electrolyte: first detection cell 108 → three-way valve 118 → flow channel 402 → three-way valve 120 → first pump 114 → three-way valve 128 → flow channel 802 → three-way valve 126 → first detection cell 108;
- movement path of second electrolyte: second detection cell 110 → three-way valve 122 → flow channel 404 → three-way valve 124 → second pump 116 → three-way valve 132 → flow channel 804 → three-way valve 130 → second detection cell 110.

While the electrolytes are circulated only through the detection cells 108 and 110 as described above, an evaluation unit 30 applies a current to the detection cells 108 and 110 to perform one complete charge/discharge cycle. After completion of the application of a current to the detection cells 108 and 110, the evaluation unit 30 records the capacity of the electrolyte in each of the detection cells 108 and 110. Herein, the "capacity of the electrolyte" means the charge or discharge capacity of the electrolyte. The capacity of the electrolyte can be calculated by integrating the applied current as a function of application time as shown in the following equation 10:

$$\underline{Equation\ 10}$$

$$Q(capacity) = \int_{\tau_0}^{\tau} i\,dt$$

Herein, the density of the current that is applied to the detection cells 108 and 110 is preferably 20-200 mA/cm$^2$. As the current density increases, the time taken for the electrolyte to be evaluated by the evaluation unit 30 decreases, but if the current density is excessively high, resistance during discharge will increase to increase the risk of side reactions. Thus, the density of the current that is applied to the detection cells 108 and 110 is preferably 100-150 mA/cm$^2$.

The electrolytes circulating through the detection cells 108 and 110 completely reflect the components of the whole electrolyte circulating through the main stack 102. Thus, the capacity fade of the detection cells 108 and 110 can be seen to be the same as the capacity fade of the electrolyte contained in the main stack 102. Thus, the evaluation unit 30 calculates the capacity fade of the detection cells 108 and 110 as shown in the following equation 11, thereby determining the capacity fade of the electrolyte contained in the main stack, that is, the electrolyte that is used in the redox flow battery:

$$\underline{Equation\ 11}$$

$$\text{capacity fade}(\%) = \left(1 - \frac{Q_F}{Q_I}\right) \times 100 = \left(1 - \frac{q_F}{q_I}\right) \times 100$$

wherein $Q_I$ is the initial capacity of the electrolyte contained in the main stack 102, and $Q_F$ is the capacity of the electrolyte in the main stack 102 after completion of current application. Also, $q_I$ is the initial capacity of the electrolyte in the detection cells 108 and 110, and $q_F$ is the capacity of the electrolyte in the detection cells 108 and 110 after completion of current application. As used herein, the term "capacity" is used in the sense of both charge capacity and discharge capacity. If equation 11 is used on the basis of charge capacity, all the capacity values in equation 11 are preferably regarded as charge capacity values for consistency of comparison. If the term "capacity" is used in the sense of discharge capacity, all the capacity values in equation 11 are also preferably regarded as discharge capacity values. The $q_1$ value is preferably previously input into the evaluation unit after it is obtained by performing the second embodiment on the electrolyte before the operation of the battery system, that is, the occurrence of capacity fade.

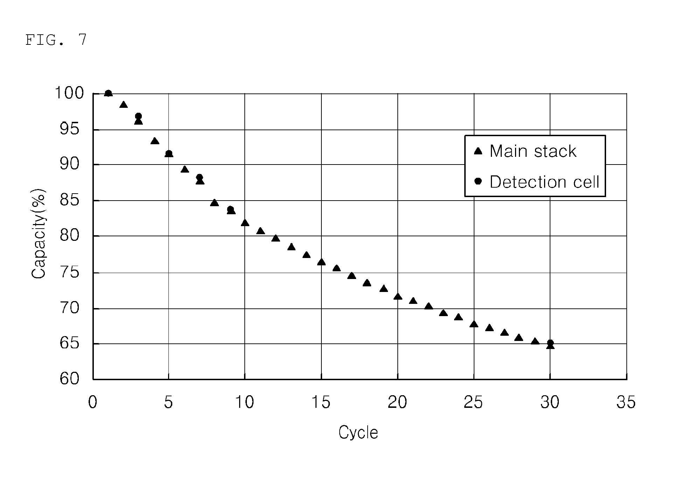

FIG. 7 is a graph showing a comparison between the capacity of the detection cells and the capacity of the main stack of the redox flow battery, measured according to the second embodiment of the present disclosure.

FIG. 7 shows the capacity of the electrolyte in the main stack 102, measured during charge and discharge of the main stack 102, and the capacity of the electrolyte in the detection cells 108 and 110, measured by the evaluation unit 30 of the present disclosure. As can be seen in FIG. 7, the capacity fade of the electrolyte in the detection cells 108 and 110, measured by the evaluation unit 30 of the present disclosure, is consistent with the actually measured capacity fade of the main stack 102, until the capacity of the electrolyte decreases from 100% to about 75%.

Third embodiment - mode for evaluation of oxidation number

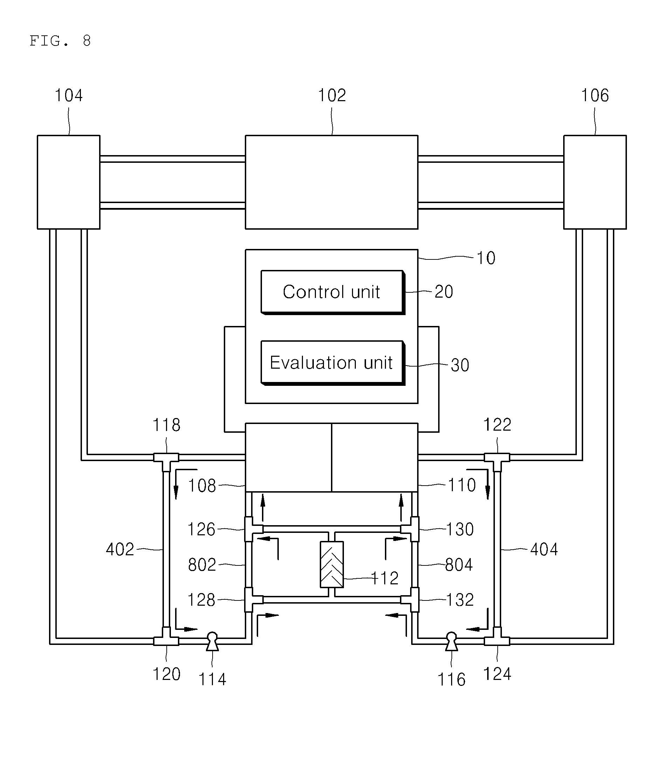

**[0050]** FIG. 8 is a view illustrating the operation of a redox flow battery evaluation system according to a third embodiment of the present disclosure.

Referring to FIG. 8, a control unit 20 is configured to control the on/off states of three-way valves 118, 120, 122, 124, 126, 128, 130 and 132 to thereby control the path of each flow channel so that electrolytes discharged from detection cells 108 and 110 will be introduced again into the detection cells 108 and 110 after passage through an agitator 112. The on/off states of three-way valves, which are controlled by the control unit 20 in the third embodiment, are as follows:

- three-way valves 118, 120, 122, 124, 126, 128, 130 and 132: "on" state.

Specifically, in the third embodiment, the three-way valves 118, 120, 122, 124, 126, 128, 130 and 132 are all maintained in an "on" state, and the movement paths of a first electrolyte and a second electrolyte in this state are as follows:

- movement path of first electrolyte: first detection valve 108 → three-way valve 118 → flow channel 402 → three-way valve 120 → first pump 114 → three-way valve 128 → agitator 112 → three-way valve 126 → first detection cell 108;
- movement path of second electrolyte: second detection cell 110 → three-way valve 122 → flow channel 404 → three-way valve 124 → second pump 116 → three-way valve 132 → agitator 112 → three-way valve 130 → second detection cell 110.

Accordingly, the first electrolyte, discharged from the first detection cell 108, and the second element discharged from the second detection cell 110 are completely mixed with each other in the agitator 112. The electrolytes mixed in the agitator 112 are introduced again into the detection cells 108 and 110, and thus the completely mixed electrolyte is present in the detection cells 108 and 110.

After mixing of the electrolytes in the agitator 112, an evaluation unit 30 applies a current to the detection cells 108 and 110. In an embodiment of the present disclosure, before the evaluation unit 30 applies a current to the detection cells 108 and 110, the control unit 20 switches off the three-way valves 126, 128, 130 and 132 so that the electrolytes will no longer be introduced into the agitator 112.

The evaluation unit 30 applies a charge current to the detection cells 108 and 110 while it measures the voltage of the detection cells 108 and 110 as a function of the state of charge (SOC). According to this measurement of the voltage, the evaluation unit 30 can produce a graph showing state-of-charge versus voltage curves of the detection cells 108 and 110. The evaluation unit 30 can evaluate the oxidation number balance of the detection cells 108 and 110 based on the inflection point position and shape of the produced voltage curve. In addition, the evaluation unit 30 can determine the oxidation number of the electrolytes in the detection cells 108 and 110 based on the stage of charge of the electrolytes.

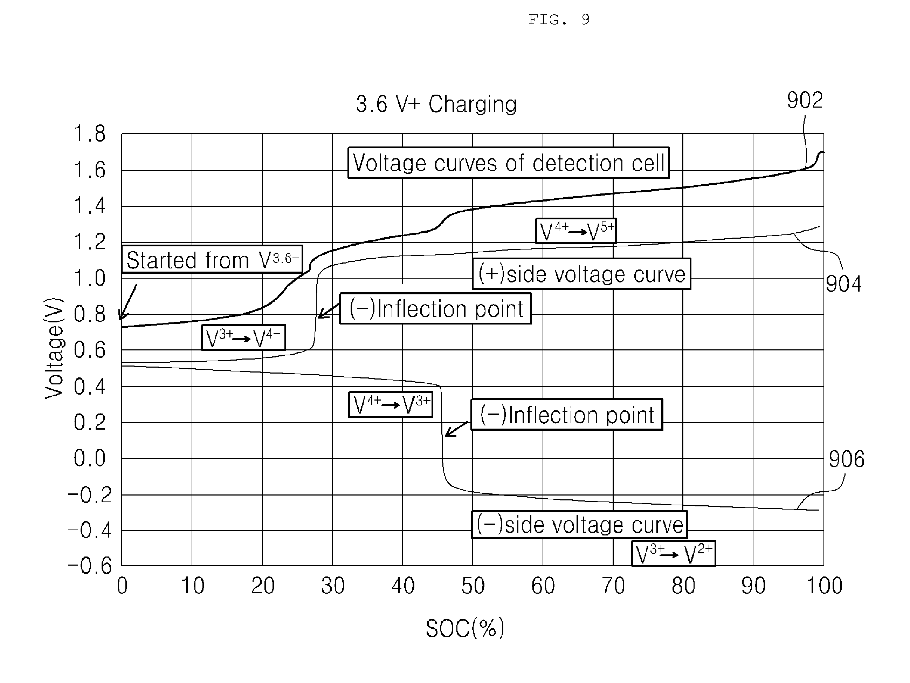

FIG. 9 is a graph showing state-of-charge voltage curves of the detection cells, produced according to the third embodiment of the present disclosure. Herein, the graph in FIG. 9 is a graph produced when the detection cells 108 and 110 are only charged by applying a current thereto.

The inflection points ((-) inflection point and (+) inflection point) on the voltage curves shown in FIG. 9 occur when the concentration of an oxidation or reduction product in the electrolytes approaches 100%. This is because the concentration of the oxidation or reduction product in equation in equation 2 is within the log function. In other words, when the active material in the electrolyte is mostly oxidized or reduced by the charge or discharge of the battery, the inflection point on the voltage curve is formed.

For example, when a vanadium redox flow battery is used in the third embodiment of the present disclosure, $V^{2+}/V^{3+}$ ions are present in the negative electrode electrolyte, and $V^{4+}/V^{5+}$ ions are present in the positive electrode electrolyte. When the vanadium redox flow battery is charged by applying a current thereto, $V^{3+}$ ions in the negative electrode electrolyte are reduced to $V^{2+}$ ions, and the concentration of $V^{2+}$ ions (reduction product) approaches 100% at the end of the reduction reaction, and thus the (-) inflection point as shown in FIG. is formed. In the same manner, when the battery is charged, $V^{4+}$ ions in the positive electrode electrolyte are oxidized to $V^{5+}$ ions, and the concentration

of $V^{5+}$ ions (oxidation product) approaches 100% at the end of the oxidation reaction, and thus the (+) inflection point as shown in FIG. 9 is formed.

Although not shown in FIG. 9, when the detection cells 108 and 110 are discharged by applying a current in other embodiments of the present disclosure, the concentration of $V^{3+}$ in the negative electrode electrolyte and the concentration of $V^{4+}$ ions in the positive electrode electrolyte approach 100% at the end of the reaction. Thus, the voltage curves and inflection points similar to those shown in FIG. 9 are formed.

If the oxidation number balance of the positive electrode electrolyte and the negative electrode electrolyte is complete, when the positive electrode electrolyte is mixed with the negative electrode electrolyte, the average oxidation number of vanadium ions in the electrolytes is 3.5. This is because $V^{2+}$/$V^{3+}$ ions are mixed with the same amount of $V^{4+}$/$V^{5+}$ ions. Herein, the average oxidation number of 3.5 does not mean that the actual oxidation number of vanadium ions is 3.5, but should be understood to mean that trivalent ions are mixed with the same amount of tetravalent ions.

For example, when the detection cells 108 and 110 are charged with 3.5-valent vanadium ions having a coordination number of 1, in the positive electrode, a first inflection point occurs when $V^{3+}$ ions having a coordination number of 0.5 are oxidized to $V^{4+}$ ions, and a second inflection point occurs at the end of charge when $V^{4+}$ ions having a coordination number of 1 are oxidized to $V^{5+}$ ions. In the negative electrode, a first inflection point occurs when $V^{4+}$ ions having a coordination number of 0.5 are reduced to $V^{3+}$ ions, and a second inflection point occurs at the end of charge when $V^{3+}$ ions having a coordination number of 1 are reduced to $V^{2+}$ ions.

From the viewpoint of a voltage that is measured in the detection cells 108 and 110, the voltage of the detection cells 108 and 110 is a difference between a (+) side voltage curve 904 and a (-) side voltage curve 906. Thus, at a point of time when the detection cells are charged with ions having a coordination number of 0.5, the first inflection points on the (+) side and (-) side voltage curves overlap each other and appear as one point. Thus, when one inflection point appears on a curve of the voltage measured after applying a current to the detection cells 108 and 110, the oxidation number balance of the positive electrode electrolyte can be determined to be complete. The oxidation number balance can be determined only using information about the first inflection point of the positive electrode side.

The cases in which the oxidation number balance of the positive electrode electrolyte with the negative electrode electrolyte is incomplete are as follows: (1) the case in which the average oxidation number of mixed electrolytes is smaller that 3.5; and (2) the case in which the average oxidation number of mixed electrolytes is greater than 3.5.

In an embodiment of the present disclosure, in the case in which the average oxidation number of the mixed electrolytes in the detection cells 108 and 110 is 3.4, in the positive electrode, an inflection point occurs when $V^{3+}$ ions having a coordination number of 0.6 are completely oxidized to $V^{4+}$ ions upon charge of the detection cells 108 and 110. In the negative electrode, an inflection point occurs when $V^{4+}$ ions having a coordination number of 0.4 are completely reduced to $V^{3+}$ ions. Thus, on a voltage curve of the detection cells 108 and 110, two inflection points caused by ions having a coordination number of 0.4 and ions having a coordination number of 0.6 appear.

In another embodiment of the present disclosure, in the case in which the average oxidation number of the mixed electrolytes in the detection cells 108 and 110 is 3.6, in the positive electrode, an inflection point occurs when $V^{3+}$ ions having a coordination number of 0.4 are completely oxidized to $V^{4+}$ ions upon charge of the detection cells 108 and 110. In the negative electrode, an inflection point occurs when $V^{4+}$ ions having a coordination number of 0.6 are completely reduced to $V^{3+}$ ions. Thus, on a voltage curve of the detection cells 108 and 110, two inflection points caused by ions having a coordination number of 0.4 and ions having a coordination number of 0.6 appear.

Thus, according to the third embodiment of the present disclosure, whether the oxidation number imbalance of active materials in the electrolytes used in the redox flow battery occurred can be determined based on the position of an inflection point on a voltage curve of the detection cells 108 and 110 and the shape of the voltage curve.

Also, according to the third embodiment of the present disclosure, the oxidation number of active materials in the electrolytes that are used in the redox flow battery can be calculated. For example, if the active materials in the electrolytes are vanadium ions, the oxidation number of vanadium ions can be calculated using the following equation 12:

Equation 12

Molar fraction of $V^{4+}$ ions = $V^{4+}$ MOL / $V^3$ MOL + $V^{4+}$ MOL = state of charge of $V^{4+}$ / (state of charge of $V^3$ + state of charge of $V^{4+}$)

Oxidation number of vanadium ions = 3 + molar fraction of $V^{4+}$ ions = state of charge of $V^{4+}$ / (state of charge of $V^3$ + state of charge of $V^{4+}$)

In FIG. 9, the state of charge of $V^{3+}$ ion is the same as the state of charge at the (+) inflection point, and the state of charge of $V^{4+}$ ions is the same as the state of charge at the (-) inflection point. Thus, the oxidation number of vanadium ions contained in the electrolytes in the detection cells 108 and 110 can be calculated as shown in equation 12, and the calculated oxidation number can be regarded as the oxidation number of the redox flow battery.

For example, when the average oxidation number of the electrolytes in the detection cells 108 and 110 is 3.4, 3 + 0.4 / (0.4 + 0.6) = 3.4 can be obtained using equation 12.

Using the oxidation number evaluation mode according to the third embodiment of the present disclosure as described above, the accurate average oxidation number of electrolytes that are used in a redox flow battery can be calculated. Based on the calculated average oxidation number, quantitative information about oxidation number imbalance can be obtained.

The capacity fade evaluation mode and oxidation number evaluation mode according to the present disclosure may be performed independently or consecutively. For example, when the oxidation number evaluation mode is performed after completion of the capacity fade evaluation mode, information about the state of charge of electrolytes can be obtained at any time through the detection cells. In addition, information about the capacity fade, oxidation number imbalance direction and oxidation number imbalance degree of the electrolytes can be obtained.

The cycle of the capacity fade evaluation mode and oxidation number evaluation mode according to the present disclosure varies depending on the type of redox flow battery used, the type of electrolyte membrane used in the battery, charge/discharge operating conditions, etc.

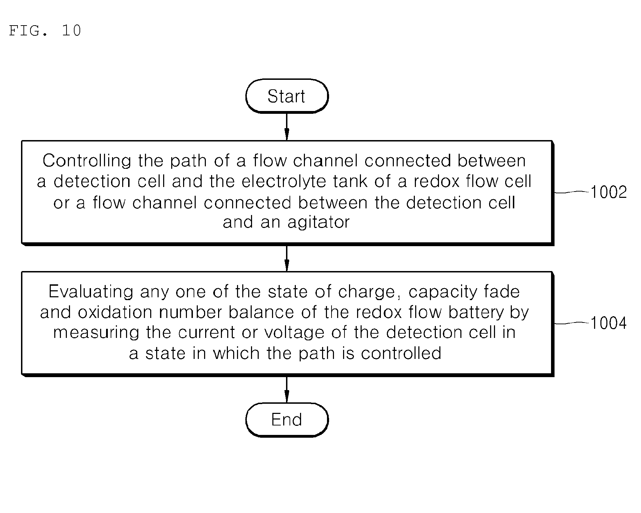

FIG. 10 is a flow chart showing a method for evaluating a redox flow battery according to an embodiment of the present disclosure.

As shown in FIG. 10, the path of either a flow channel connected between a detection cell and the electrolyte tank of a redox flow battery or a flow channel connected between the detection cell and an agitator is controlled (step 1002). Thereafter, the current or voltage of the detection cell following the control of the path is measured to evaluate any one of the state of charge, capacity fade and oxidation number balance of an electrolyte that is used in the redox flow battery (step 1004).

In an embodiment of the present disclosure, step 1002 of controlling the path may include the step of controlling the path of the flow channel so that the electrolyte discharged from the electrolyte tank will introduced again into the electrolyte tank after passage through the detection cell. In this case, step 1004 of evaluating any one of the state of charge, capacity fade and oxidation number balance of the electrolyte that is used in the redox flow battery may include the step of evaluating the state of charge of the electrolyte in the detection cell. Also, the step of evaluating the state of charge of the electrolyte in the detection cell may include the steps of: measuring the open circuit voltage of the detection cell; and determining the state of charge of the electrolyte of the detection cell based on the open circuit voltage.

In another embodiment of the present disclosure, step 1002 of controlling the path may include the step of controlling the path of the flow channel so that the electrolyte discharged from the detection cell will be introduced again into the detection cell. In this case, step 1004 of evaluating any one of the state of charge, capacity fade and oxidation number balance of the electrolyte that is used in the redox flow battery may include the step of evaluating the capacity fade of the electrolyte in the detection cell. Also, the step of evaluating the capacity fade of the electrolyte in the detection cell may include the steps of: applying a current to the detection cell; and determining the capacity fade of the electrolyte of the detection cell, based on the initial capacity of the electrolyte of the detection cell, and the capacity of the electrolyte of the detection cell, measured after completion of the application of the current to the detection cell.

In still another embodiment of the present disclosure, step 1002 of controlling the path may include the step of controlling the path of the flow channel so that the electrolyte discharged from the detection cell will be introduced again into the detection cell after passage through the detection cell. In this case, step 1004 of evaluating any one of the state of charge, capacity fade and oxidation number balance of the electrolyte that is used in the redox flow battery may include the step of evaluating the oxidation number balance of the electrolyte in the detection cell. Also, the step of evaluating the oxidation number balance of the electrolyte in the detection cell may include the step of evaluating the oxidation number balance of the electrolyte of the detection cell based on the position of an inflection point on a state-of-charge versus voltage curve of the detection cell, produced by applying a current to the detection cell, and based on the shape of the voltage curve.

According to the present disclosure as described above, there is an advantage in that it can quickly cope with the capacity fade problem of a redox flow battery by evaluating the information of the positive and negative electrode electrolytes on battery capacity fade and information about the valence balance of the positive electrode and negative electrode electrolytes *in situ.*

In addition, according to the present disclosure, there are advantages in that the energy of a redox flow battery can be efficiently controlled and steadily used, and the reliability of performance of the redox flow battery can be improved.

While various embodiments have been described above, it will be understood to those skilled in the art that the embodiments described are by way of example only. Accordingly, the disclosure described herein should not be limited based on the described embodiments.

**Claims**

1. A system for evaluating a redox flow battery, comprising:

   a control unit configured to control a path of one or more of a flow channel connected between a detection cell and the redox flow battery and a flow channel connected between the detection cell and an agitator; and
   an evaluation unit configured to evaluate at least one of a state of charge, capacity fade and oxidation number balance of an electrolyte used in the redox flow battery, by measuring a current or voltage of the detection cell based on the controlling of the path by the control unit.

2. The system of claim 1,
   wherein the control unit is configured to control the path of the flow channel so that the electrolyte discharged from a electrolyte tank of the redox flow battery is introduced again into the electrolyte tank after passage through the detection cell, and
   wherein the evaluation unit is configured to measure an open circuit voltage of the detection cell and determine the state of charge of the electrolyte in the detection cell based on the measured open circuit voltage.

3. The system of claim 1,
   wherein the control unit is configured to control the path of the flow channel so that the electrolyte discharged from the detection cell is introduced again into the detection cell, and
   wherein the evaluation unit is configured to evaluate the capacity fade of the electrolyte in the detection cell.

4. The system of claim 3, wherein the evaluation unit is configured to apply a current to the detection cell and determine the capacity fade of the electrolyte of the detection cell based on an initial capacity of the electrolyte of the detection cell and a capacity of the electrolyte of the detection cell, measured after completion of the application of the current to the detection cell.

5. The system of claim 1,
   wherein the control unit is configured to control the path of the flow channel so that the electrolyte discharged from the detection cell is introduced again into the detection cell after passage through the agitator; and
   wherein the evaluation unit is configured to evaluate the oxidation number balance of the electrolyte in the detection cell.

6. The system of claim 5, wherein the evaluation unit is configured to evaluate the oxidation number balance of the electrolyte of the detection cell based on a position of an inflection point on a state-of-charge versus voltage curve of the detection cell, produced by applying a current to the detection cell, and a shape of the voltage curve, andwherein the evaluation unit is configured to determine the oxidation number of the electrolyte of the detection cell based on the state of charge of the electrolyte of the detection cell at the inflection point.

7. The system of claim 1, wherein the flow channel connected between the detection cell and the redox flow channel includes:

a first flow channel configured to move the electrolyte from the detection cell to the redox flow battery;
a second flow channel configured to move the electrolyte from the redox flow battery to the detection cell;
a first three-way valve disposed in the first flow channel;
a second three-way valve disposed in the second flow channel; and
a third flow channel connecting the first three-way valve with the second three-way valve.

8. The system of claim 1, wherein the flow channel connected between the detection cell and the agitator includes:

a fourth flow channel configured to move the electrolyte from the redox flow battery to the detection cell;
a third three-way valve and fourth three-way valve disposed in the fourth flow channel;
a fifth flow channel connecting the third three-way valve with the agitator and configured to move the electrolyte from the fourth flow channel to the agitator; and
a sixth flow channel connecting the fourth three-way valve with the agitator and configured to move the electrolyte from the agitator to the fourth flow channel.

9. A redox flow battery system comprising:

a redox flow battery;
a detection cell into which an electrolyte discharged from the redox flow battery is introduced;
an agitator configured to agitate the electrolyte discharged from the redox flow battery;
a control unit configured to control a path of one or more of a flow channel connected between a detection cell and the redox flow battery and a flow channel connected between the detection cell and an agitator; and
an evaluation unit configured to evaluate at least one of a state of charge, capacity fade and oxidation number balance of an electrolyte, which is used in the redox flow battery, by measuring a current or voltage of the detection cell based on the controlling of the path by the control unit.

10. A method for evaluating a redox flow battery, comprising the steps of:

controlling a path of one or more of a flow channel connected between a detection cell and the redox flow battery and a flow channel connected between the detection cell and an agitator; and
evaluating at least one of a state of charge, capacity fade and oxidation number balance of an electrolyte, which is used in the redox flow battery, by measuring a current or voltage of the detection cell based on the controlling of the path.

11. The method of claim 10,
wherein the step of controlling the path comprises the step of controlling the path of the flow channel so that the electrolyte discharged from an electrolyte tank of the redox flow battery is introduced again into the electrolyte tank after passage through the detection tank, and
wherein the step of evaluating at least one of the state of charge, capacity fade and oxidation number balance of the electrolyte which is used in the redox flow battery comprises the step of:

measuring an open circuit voltage of the detection cell; and
determining the state of charge of the electrolyte in the detection cell based on the measured open circuit voltage.

12. The method of claim 10,
wherein the step of controlling the path comprises the step of controlling the path of the flow channel so that the electrolyte discharged from the detection cell is introduced again into the detection cell, and
wherein the step of evaluating at least one of the state of charge, capacity fade and oxidation number balance of the electrolyte which is used in the redox flow battery comprises the step of evaluating the capacity fade of the electrolyte in the detection cell.

13. The method of claim 12, wherein the step of evaluating the capacity fade of the electrolyte in the detection cell comprises the steps of:

applying a current to the detection cell; and
determining the capacity fade of the electrolyte of the detection cell based on an initial capacity of the electrolyte of the detection cell and a capacity of the electrolyte of the detection cell, measured after completion of the application of the current to the detection cell.

14. The method of claim 10,
   wherein the step of controlling the path comprises the step of controlling the path of the flow channel so that the electrolyte discharged from the detection cell is introduced again into the detection cell after passage through the agitator, and
   wherein the step of evaluating at least one of the state of charge, capacity fade and oxidation number balance of the electrolyte comprises the step of evaluating the oxidation number balance of the electrolyte in the detection cell.

15. The method of claim 14, wherein the step of evaluating the oxidation number balance of the electrolyte in the detection cell comprises the step of evaluating the oxidation number balance of the electrolyte of the detection cell based on a position of an inflection point on a state-of-charge versus voltage curve of the detection cell, produced by applying a current to the detection cell, and a shape of the voltage curve, andwherein the oxidation number of the electrolyte of the detection cell is determined based on the state of charge of the electrolyte of the detection cell at the inflection point.

FIG. 1

FIG. 2

(a)  (b)

FIG. 3

(a)

(b)

(c)

(d)

FIG. 4

FIG. 5

FIG. 6

FIG. 7

FIG. 8

FIG. 9

3.6 V+ Charging

Voltage curves of detection cell

902

$V^{4+} \rightarrow V^{5+}$

Started from $V^{3.6-}$

(+)side voltage curve

904

(−)Inflection point

$V^{3+} \rightarrow V^{4+}$

$V^{4+} \rightarrow V^{3+}$

(−)Inflection point

906

(−)side voltage curve

$V^{3+} \rightarrow V^{2+}$

Voltage(V)

1.8
1.6
1.4
1.2
1.0
0.8
0.6
0.4
0.2
0.0
-0.2
-0.4
-0.6

0   10   20   30   40   50   60   70   80   90   100

SOC(%)

EP 2 908 374 A1

FIG. 10

```
                        ( Start )
                            |
                            v
  +---------------------------------------------------+
  | Controlling the path of a flow channel connected |
  | between a detection cell and the electrolyte      | ~1002
  | tank of a redox flow cell or a flow channel       |
  | connected between the detection cell and an       |
  | agitator                                          |
  +---------------------------------------------------+
                            |
                            v
  +---------------------------------------------------+
  | Evaluating any one of the state of charge,        |
  | capacity fade and oxidation number balance of     | ~1004
  | the redox flow battery by measuring the current   |
  | or voltage of the detection cell in a state in    |
  | which the path is controlled                      |
  +---------------------------------------------------+
                            |
                            v
                         ( End )
```

**EUROPEAN SEARCH REPORT**

Application Number

EP 15 15 4653

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2012/135473 A2 (ENERVAULT CORP [US]; CHANG ON KOK [US]; SOPCHAK DAVID ANDREW [US]; PHA) 4 October 2012 (2012-10-04)<br>* paragraph [0009] *<br>* paragraph [0066] *<br>* paragraph [0078]; figure 1, *<br>* paragraph [0089] - paragraph [0094] *<br>----- | 1-15 | INV.<br>H01M8/18<br>G01R31/36<br>H01M8/20<br>H01M8/04 |
| X | WO 90/03666 A1 (UNISEARCH LTD [AU]) 5 April 1990 (1990-04-05)<br>* page 2, paragraph 3 - page 5, paragraph 1 *<br>* page 14, paragraph 5 - page 15, paragraph 2 *<br>* page 12, paragraph 4 - page 13, paragraph 1 *<br>* page 22 - page 23 *<br>----- | 1-15 | |
| X | JP 2013 037857 A (SUMITOMO ELECTRIC INDUSTRIES) 21 February 2013 (2013-02-21)<br>* paragraph [0008]; figure 1 *<br>* paragraph [0013] - paragraph [0015] *<br>* paragraph [0029] - paragraph [0030] *<br>----- | 1-15 | |
| X | JP 2003 173812 A (SUMITOMO ELECTRIC INDUSTRIES; KANSAI ELECTRIC POWER CO) 20 June 2003 (2003-06-20)<br>* paragraph [0001] *<br>* paragraph [0013] *<br>* paragraph [0024] - paragraph [0028] *<br>* paragraph [0031] - paragraph [0032] *<br>----- | 1-15 | TECHNICAL FIELDS SEARCHED (IPC)<br><br>H01M<br>G01R |
| X | JP H07 192747 A (AGENCY IND SCIENCE TECHN; EBARA CORP) 28 July 1995 (1995-07-28)<br>* paragraph [0008] - paragraph [0016]; figure 1 *<br>* paragraph [0031] *<br>----- | 1-15 | |

-/--

The present search report has been drawn up for all claims

| Place of search | Date of completion of the search | Examiner |
|---|---|---|
| The Hague | 30 June 2015 | Gamez, Agnès |

Europäisches
Patentamt

European
Patent Office

Office européen
des brevets

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | EP 2 824 746 A1 (OCI CO LTD [KR]) 14 January 2015 (2015-01-14) <br> * paragraph [0017] - paragraph [0024] * <br> * paragraph [0030] - paragraph [0034] * <br> * paragraph [0042] - paragraph [0043] * <br> ----- | 1,10 | |

**TECHNICAL FIELDS SEARCHED (IPC)**

The present search report has been drawn up for all claims

| Place of search | Date of completion of the search | Examiner |
|---|---|---|
| The Hague | 30 June 2015 | Gamez, Agnès |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**ANNEX TO THE EUROPEAN SEARCH REPORT**
**ON EUROPEAN PATENT APPLICATION NO.**   EP 15 15 4653

This annex lists the patent family members relating to the patent documents cited in the above-mentioned European search report.
The members are as contained in the European Patent Office EDP file on
The European Patent Office is in no way liable for these particulars which are merely given for the purpose of information.

30-06-2015

| Patent document cited in search report | | Publication date | Patent family member(s) | | Publication date |
|---|---|---|---|---|---|
| WO 2012135473 | A2 | 04-10-2012 | AU | 2012236451 A1 | 31-10-2013 |
| | | | CN | 103534858 A | 22-01-2014 |
| | | | EP | 2692010 A2 | 05-02-2014 |
| | | | JP | 2014514704 A | 19-06-2014 |
| | | | KR | 20140016918 A | 10-02-2014 |
| | | | US | 2013084506 A1 | 04-04-2013 |
| | | | US | 2015155727 A1 | 04-06-2015 |
| | | | WO | 2012135473 A2 | 04-10-2012 |
| WO 9003666 | A1 | 05-04-1990 | NONE | | |
| JP 2013037857 | A | 21-02-2013 | NONE | | |
| JP 2003173812 | A | 20-06-2003 | NONE | | |
| JP H07192747 | A | 28-07-1995 | JP | 3193990 B2 | 30-07-2001 |
| | | | JP | H07192747 A | 28-07-1995 |
| EP 2824746 | A1 | 14-01-2015 | CN | 104282927 A | 14-01-2015 |
| | | | EP | 2824746 A1 | 14-01-2015 |
| | | | KR | 20150007566 A | 21-01-2015 |
| | | | US | 2015017556 A1 | 15-01-2015 |

EPO FORM P0459

For more details about this annex : see Official Journal of the European Patent Office, No. 12/82